Europäisches Patentamt

European Patent Office

Office européen des brevets

(19)

(11) Veröffentlichungsnummer : **0 452 766 B1**

(12) **EUROPÄISCHE PATENTSCHRIFT**

(45) Veröffentlichungstag der Patentschrift :
28.06.95 Patentblatt 95/26

(51) Int. Cl.⁶ : **G01R 33/032, G01R 33/12**

(21) Anmeldenummer : **91105513.5**

(22) Anmeldetag : **08.04.91**

(54) **Messverfahren und Messanordnung zur Bestimmung des Richtfaktors bei flexiblen Magnetogrammträgern.**

(30) Priorität : **14.04.90 DE 4012240**

(43) Veröffentlichungstag der Anmeldung :
**23.10.91 Patentblatt 91/43**

(45) Bekanntmachung des Hinweises auf die
Patenterteilung :
**28.06.95 Patentblatt 95/26**

(84) Benannte Vertragsstaaten :
**DE FR GB NL**

(56) Entgegenhaltungen :
**SU-A- 540 228
US-A- 3 859 643
US-A- 4 816 761**

(56) Entgegenhaltungen :
**PATENT ABSTRACTS OF JAPAN vol. 013, no.
329 (P-904)25July 1989 & JP-A-01 093 702 (
TOYOTA MOTOR CORP ) 12 April 1989
PATENT ABSTRACTS OF JAPAN vol. 007, no.
093 (P-192)19April 1983 & JP-A-58 019 753 (
NIPPON DENKI KK ) 4 February 1983
PATENT ABSTRACTS OF JAPAN vol. 007, no.
125 (P-200)31 May1983 & JP-A-58 041 450 (
NIPPON DENKI KK ) 10 March 1983**

(73) Patentinhaber : **BASF Aktiengesellschaft
Carl-Bosch-Strasse 38
D-67063 Ludwigshafen (DE)**

(72) Erfinder : **Suettinger, Rudolf, Dr.
Karl-Christ-Strasse 17
W-6900 Heidelberg (DE)**
Erfinder : **Klein, Ursula
Max-Planck-Strasse 26
W-6703 Limburgerhof (DE)**

EP 0 452 766 B1

## Beschreibung

Die Erfindung betrifft ein Meßverfahren und eine Meßanordnung zur Bestimmung des Richtfaktors der Magnetschicht von flexiblen Magnetogrammträgern.

Bisher wurde der Richtfaktor durch Messen der Magnetisierung (Remanenz) in der Längserstreckung des Magnetogrammträgers und quer dazu bestimmt, beispielsweise mit Hilfe eines in der Fachliteratur (S. Foner: "Review Science Instruments", July 1959, Vol. 30, No. 7, Seiten 548-557) beschriebenen Schwingmagnetometers. Dabei wird der Richtfaktor als Verhältnis der beiden Meßgrößen zueinander erhalten.

Von Nachteil ist dabei, daß zur Durchführung der Messungen Proben aus dem Magnetogrammträger geschnitten werden müssen und die Messung daher nicht kontinuierlich mit dem Herstellablauf, im sog. on-line-Betrieb, durchführbar ist.

Dementsprechend war die Aufgabe zu lösen, ein Meßverfahren und eine Meßanordnung zur Bestimmung des Richtfaktors bei flexiblen Magnetogrammträgern zu entwickeln, die eine Messung am Magnetogrammträger ohne Probenpräparation ermöglichen.

Der auf das Meßverfahren sich beziehende Aufgabenteil wurde dadurch gelöst, daß der Magnetogrammträger mit linear polarisiertem Infrarotlicht, insbesondere der Wellenlänge zwischen 2,5 $\mu$m und 25 $\mu$m, beaufschlagt wird und die Intensität des durch den Magnetogrammträger hindurchgehenden Teils des Lichtes gemessen und daraus mit Hilfe einer mathematischen Beziehung oder einem Kurvendiagramm in Abhängigkeit von der Schichtdicke der Richtfaktor bestimmt wird, wobei der Magnetogrammträger in seiner Längserstreckung und der polarisierte Lichtstrahl zueinander so eingestellt werden, daß maximale Intensität des durchgehenden Lichtes erhalten wird.

Die Lösung des die Meßanordnung betreffenden Teils der Aufgabe ist gekennzeichnet durch die aufeinanderfolgende Anordnung einer Infrarotlichtquelle, eines Polarisators, eines Trägers für den Magnetogrammträger und eines Infrarotlichtdetektors, der mit einer eine Anzeigeeinrichtung einschließenden Auswerteschaltung verbunden ist, wobei der Polarisator oder der Träger, jeder in seiner Ebene, drehbar ist.

Weitere Einzelheiten der Erfindung sind anhand eines in der Zeichnung schematisch dargestellten Ausführungsbeispiels nachfolgend beschrieben.

Es zeigen

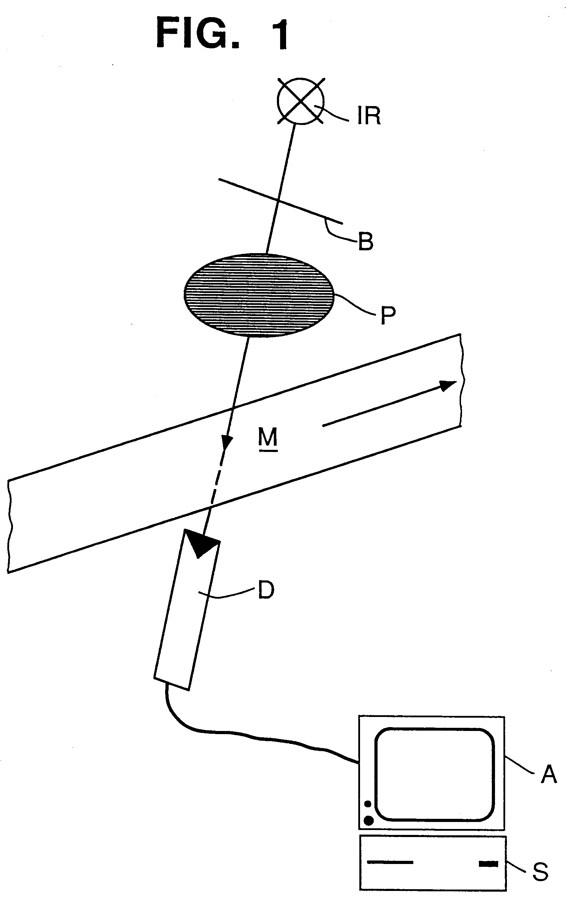

Figur 1    einen schematischen Aufbau der Meßanordnung

Figur 2    die Abhängigheit des Richtfaktors von der Intensität des durch den Magnetogrammträger hindurchgehenden Infrarotlichtes und von der Schichtdicke in einem Kurvendiagramm.

Ausgehend von der Feststellung, daß die Magnetschicht auf einem flexiblen, transparenten Trägermaterial infolge der Ausrichtung der Magnetpigmente eine bezüglich der Infrarotlichtdurchlässigkeit ausgeprägte Anisotropie besitzt, wird bei der erfindungsgemäßen Meßmethode der Richtfaktor $R_f$ eines derartigen Magnetogrammträgers in Abhängigkeit von dieser Infrarotlicht polarisierenden Wirkung ermittelt.

Hierzu wird Infrarotlicht einer Wellenlänge zwischen 2,5 $\mu$m und 25 $\mu$m aus einer Infrarotlichtquelle IR über eine Blende B durch einen Infrarotlicht-Polarisator P geleitet. Das linear polarisierte Licht trifft auf den Magnetogrammträger M, der über einen transparenten Träger T geführt ist. Der Träger oder der Polarisator ist neigbar gehalten, um zweckmäßigerweise als Einfallswinkel den Brewsterwinkel zur Eliminierung von Interferenzerscheinungen einstellen zu können. Das in Abhängigkeit von der Schichtdicke, dem Ausrichtungsgrad der Magnetpigmente und der Stellung des Magnetogrammträgers zur Polarisationsebene diesen durchdringende Infrarotlicht erzeugt in einem Detektor D Meßsignale, die einer Auswerteschaltung S, beispielsweise einem Mikroprozessor, zugeführt werden. Die Auswerteschaltung ist mit einer Anzeigeeinrichtung A verbunden, um die Intensität des detektierten Infrarotlichtes ablesen zu können.

Zum Einstellen maximaler Intensität $I_{max}$ des durchgehenden Lichtes ist der Träger T für den Magnetogrammträger oder der Polarisator P in deren Ebene drehbar gehalten.

Mit der gemessenen maximalen Intensität $I_{max}$ kann der Richtfaktor $R_f$ mit Hilfe der mathematischen Beziehung

$$R_f = \frac{I_{max} + \beta_{max}}{a_{max}} \quad (1)$$

bestimmt werden. Dabei sind

$a_{max}$    eine von der Dicke d und der Zusammensetzung der Magnetschicht abhängige Größe, die durch eine Eichbeziehung $I_{max} \sim R_f$ bestimmt wird.

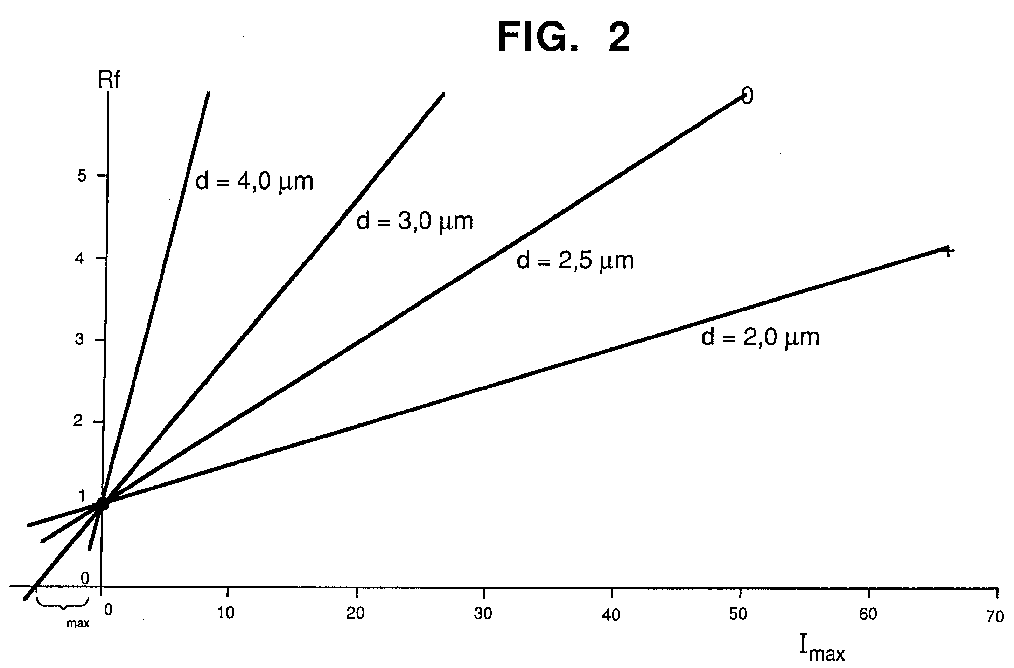

$\beta_{max}$    ist der Abszissenabschnitt der vorstehend genannten Eichbeziehung (1) in der Darstellung von Figur 2.

Zweckmäßigerweise wird die Berechnung des Richtfaktors $R_f$ ebenfalls mittels der Auswerteschaltung S vorgenommen und anschließend zur Anzeige gebracht.

2

In Figur 2 ist beispielhaft der Richtfaktor $R_f$ in Abhängigkeit von der Intensität $I_{max}$ und der Magnetschichtdicke d dargestellt.

Das vorstehend beschriebene Meßverfahren und die Meßanordnung dafür erfüllen alle Voraussetzungen für eine Richtfaktormessung im on-line-Betrieb.

## Patentansprüche

1. Meßverfahren zur Bestimmung des Richtfaktors der Magnetschicht von flexiblen Magnetogrammträgern, dadurch gekennzeichnet, daß der Magnetogrammträger mit linear polarisiertem Infrarotlicht, insbesondere der Wellenlänge zwischen 2,5 μm und 25 μm, beaufschlagt wird und die Intensität des durch den Magnetogrammträger hindurchgehenden Teils des Lichtes gemessen und daraus mit Hilfe einer mathematischen Beziehung oder einem Kurvendiagramm in Abhängigkeit von der Schichtdicke der Richtfaktor bestimmt wird, wobei der Magnetogrammträger in seiner Längserstreckung und der polarisierte Lichtstrahl zueinander so eingestellt werden, daß maximale Intensität des durchgehenden Lichtes erhalten wird.

2. Meßverfahren nach Anspruch 1, dadurch gekennzeichnet, daß das polarisierte Infrarotlicht unter dem Brewsterwinkel auf den Magnetogrammträger gerichtet wird.

3. Meßanordnung zur Durchführung des Meßverfahrens nach Anspruch 1, gekennzeichent durch die aufeinanderfolgende Anordnung einer Infrarotlichtquelle (IR), einer Blende (B), eines Polarisators (P), eines Trägers (T) für den Magnetogrammträger (M) und eines Infrarotlichtdetektors (D), der mit einer eine Anzeigeeinrichtung (A) einschließenden Auswerteschaltung (S) verbunden ist, wobei der Polarisator oder der Träger, jeder in seiner Ebene, drehbar ist.

4. Meßanordnung nach Anspruch 3, dadurch gekennzeichnet, daß der Träger (T) für den Magnetogrammträger (M) zur Polarisationsebene neigbar ist.

5. Meßanordnung nach Anspruch 3, dadurch gekennzeichnet, daß der Polarisator (P) zu der Ebene des Trägers (T) neigbar ist.

## Claims

1. A measuring method for determining the orientation ratio of the magnetic layer of flexible magnetic recording media, wherein the magnetic recording medium is exposed to linearly polarized infrared light, in particular having a wavelength of from 2.5 to 25 μm, the intensity of that part of the light which is transmitted by the magnetic recording medium is measured and the orientation ratio is determined from this with the aid of a mathematical relationship or a graph as a function of the layer thickness, the playing direction of the magnetic recording medium and the polarized light beam being adjusted with respect to one another so that maximum intensity of the transmitted light is obtained.

2. A measuring method as claimed in claim 1, wherein the polarized infrared light is directed at the Brewster angle at the magnetic recording medium.

3. A measuring arrangement for carrying out the measuring method as claimed in claim 1, comprising the successive arrangement of an infrared light source (IR), an aperture (B), a polarizer (P), a support (T) for the magnetic recording medium (M) and an infrared light detector (D) which is connected to an evaluation circuit (S) including a display means (A), the polarizer or the support being rotatable, each in its plane.

4. A measuring arrangement as claimed in claim 3, wherein the support (T) for the magnetic recording medium (M) can be inclined with respect to the plane of polarization.

5. A measuring arrangement as claimed in claim 3, wherein the polarizer (P) can be inclined with respect to the plane of the support (T).

**Revendications**

1. Procédé de mesure pour la détermination du facteur de directivité de la couche magnétique de supports souples d'enregistrement magnétique, caractérisé en ce que le support d'enregistrement magnétique est frappé par de la lumière infrarouge polarisée linéairement, ayant en particulier une longueur d'onde comprise entre 2,5 $\mu$m et 25 $\mu$m, l'intensité de la fraction de la lumière qui passe à travers le support d'enreistrement magnétique est mesurée et le facteur de directivité est déterminé à partir du résultat de la mesure en fonction de l'épaisseur de couche, à l'aide d'une relation mathématique ou d'un diagramme, l'étendue en longueur du support d'enregistrement magnétique et le faisceau de lumière polarisée étant réglés l'un par rapport à l'autre de sorte qu'une intensité maximale de la lumière passante soit obtenue.

2. Procédé de mesure selon la revendication 1, caractérisé en ce que la lumière infrarouge polarisée est dirigée vers le support d'enregistrement magnétique sous l'angle d'incidence brewstérienne.

3. Dispositif de mesure pour l'exécution du procédé de mesure selon la revendication 1, caractérisé par la disposition successive d'une source de lumière infrarouge (IR), d'un diaphragme (B), d'un polariseur (P), d'un support (T) pour le support d'enregistrement magnétique (M) et d'un détecteur de lumière infrarouge (D) qui est relié à un circuit d'évaluation (S) comprenant un dispositif d'affichage (A), le polariseur ou le support pouvant tourner, chacun dans son plan.

4. Dispositif de mesure selon la revendication 3, caractérisé en ce que le support (T) pour le support d'enregistrement magnétique (M) est inclinable par rapport au plan de polarisation.

5. Dispositif de mesure selon la revendication 3, caractérisé en ce que le polariseur (P) est inclinable par rapport au plan du support (T).

# FIG. 1

IR

B

P

M

D

A

S

FIG. 2